Europäisches Patentamt

European Patent Office

Office européen des brevets

(11) Veröffentlichungsnummer: **0 198 862 B1**

# EUROPÄISCHE PATENTSCHRIFT

(45) Veröffentlichungstag der Patentschrift: **15.01.92**

(51) Int. Cl.5: **H03D 3/00**

(21) Anmeldenummer: **85905057.7**

(22) Anmeldetag: **11.10.85**

(86) Internationale Anmeldenummer:
**PCT/DE85/00399**

(87) Internationale Veröffentlichungsnummer:
**WO 86/02505 (24.04.86 86/09)**

(54) **VERFAHREN UND SCHALTUNGSANORDNUNG ZUM UMSETZEN FREQUENZMODULIERTER SIGNALE ÜBER MINDESTENS EINE ZWISCHENFREQUENZ IN NIEDERFREQUENZSIGNALE.**

(30) Priorität: **16.10.84 DE 3438286**

(43) Veröffentlichungstag der Anmeldung:
**29.10.86 Patentblatt 86/44**

(45) Bekanntmachung des Hinweises auf die Patenterteilung:
**15.01.92 Patentblatt 92/03**

(84) Benannte Vertragsstaaten:
**AT BE CH DE FR GB IT LI LU NL SE**

(56) Entgegenhaltungen:
**EP-A- 0 075 071**
**DE-A- 3 147 493**
**FR-A- 2 497 039**
**US-A- 2 282 974**

(73) Patentinhaber: **H. u. C. Elektronik GmbH**
**Gustav-Meyer-Allee 25**
**W-1000 Berlin 65(DE)**

(72) Erfinder: **HANSEN, Jens**
**Klopstockstrasse 1-3**
**W-1000 Berlin 21(DE)**

(74) Vertreter: **Christiansen, Henning, Dipl.-Ing.**
**Patentanwalt CHRISTIANSEN Pacelliallee 43/45**
**W-1000 Berlin 33(DE)**

EP 0 198 862 B1

## Beschreibung

Die Erfindung betrifft eine Schaltungsanordnung der im Oberbegriff des Anspruchs 1 angegebenen Art.

In der DE-A-31 47 493 ist eine Filter- und Demodulationsschaltung beschrieben, die mit einer Mitlauffilteranordnung versehen ist. Das empfangene Signal wird dabei über eine oder mehrere Mischstufen in zwischenfrequente Signale umgewandelt, die über Zwischenfrequenzfilter einem Demodulator zugeleitet werden, in dem sie in Niederfrequenzsignale umgewandelt werden. Um Störungen so gering als möglich zu halten, sind die Filter schmalbandig ausgebildet, wobei von der Ausgangsspannung des Demodulators eine Nachsteuerspannung abgeleitet wird, die die Resonanzfrequenz des dem Demodulator vorgeschalteten schmalbandigen Zwischenfrequenz-Filters derart verschiebt, daß der jeweilige Momentanwert der Zwischenfrequenz stets innerhalb des Durchlaßbereiches des Filters liegt.

Da die Erzeugung der Steuerspannung zeitlich nach der Mischung und der Selektion erfolgt, treten durch die Rückwärtssteuerung Steuerverzögerungen auf, die im wesentlichen durch die Gruppenlaufzeiten der Filter gegeben sind. Die Rausch- und Störbefreiung des Empfangssignals wird zwar einerseits mit steigender Schmalbandigkeit größer, andererseits erhöht sich aber auch die Gruppenlaufzeit des oder der Filter und somit auch die Steuerverzögerung. Das bedeutet, daß die Steuerspannung und die Zwischenfrequenz zeitlich verschoben sind, und es entsteht eine Relativbewegung zwischen dem Filter bzw. dem Oszillator und der Zwischenfrequenz. Je größer die zeitliche Änderung der Zwischenfrequenz ist, desto höher ist die Relativbewegung. Außerdem wird aufgrund des Phasenwinkels zwischen Steuerspannung und Zwischenfrequenzbewegung die Zwischenfrequenz in der Phase moduliert, wobei diese Störmodulation sich der Nutzfrequenzmodulation überlagert.

Dabei ist es weiterhin bekannt, die Zwischenfrequenz über einen Phasenmodulator zu der durch die Steuerverzögerung auftretenden Störphasenmodulation gegenphasig zu modulieren. Der Grad der Störmodulation ist proportional zur zeitlichen Änderung der Zwischenfrequenz und nimmt daher mit steigender Frequenz zu. Dadurch entsteht im höheren Niederfrequenzbereich eine Amplitudenüberhöhung, wodurch wiederum die Relativbewegung und damit die Störphasenmodulation erhöht wird. Durch diese zum Schwingen neigende Mitkopplung wird die Nachführbarkeit der Filter bzw. des Oszillators stark herabgesetzt. Dieser Effekt wird durch die bekannte Schaltung noch nicht ausreichend kompensiert.

Der Erfindung liegt daher die Aufgabe zugrunde, eine Schaltungsanordnung der eingangs genannten Gattung anzugeben, zum Umsetzen frequenzmodulierter Signale über mindestens eine Zwischenfrequenz in Niederfrequenzsignale zu schaffen, bei denen die Relativbewegung und die Störphasenmodulation im gesamten Niederfrequenzbereich bei Anwendung schmalbandiger Filter gering gehalten wird, so daß die Filter oder der Oszillator der Mischstufe ohne Störbeeinflussung nachgeführt werden können.

Diese Aufgabe wird durch die Merkmale des Anspruchs 1 gelöst.

Durch Anordnung des Phasenmodulators noch vor den Zwischenfrequenzstufen läßt sich mittels einfacher Schaltmaßnahmen die durch die Steuerverzögerung bedingte Störphasenmodulation vollständig kompensieren und die Relativbewegung zwischen der Zwischenfrequenz und den Filtern verringern, so daß schmalbandige Filter eingesetzt werden können, die eine wesentliche zusätzliche Verbesserung der Rausch- und Störbefreiung mit sich bringen.

Gemäß einer vorteilhaften Weiterbildung der Erfindung wird in den Nachsteuerzweig mindestens ein Hochpaß geschaltet, der dem Phasenmodulator die Steuerspannung nur in dem höheren Niederfrequenzbereich zuleitet, bei dem ohne Gegenmodulation die Amplitudenüberhöhung auftritt. Da die tiefen Niederfrequenz-Bereiche abgesperrt werden, muß die Modulationskennlinie linear sein. Die Verwendung eines Hochpasses bietet einen weiteren Vorteil, da die jedem Hochpaß eigene Voreilung zum Teil die Steuerverzögerung kompensiert.

Da der Phasenmodulator gegenüber den Mitlauffiltern breitbandig ausgebildet ist, hat er keinen Einfluß auf die Nahselektion, es erhöht sich jedoch die Weitabselektion.

Durch die in den weiteren Unteransprüchen angegebenen Maßnahmen sind zusätzliche Weiterbildungen und Verbesserungen möglich.

Ausführungsbeispiele der Erfindung sind in der Zeichnung dargestellt und werden in der nachfolgenden Beschreibung näher erläutert. Es zeigen:

Figur 1 die schaltungsgemäße Ausgestaltung eines ersten Ausführungsbeispiels, bei dem mehrere Mitlauffilter nachgesteuert werden und ein Phasenmodulator vorgesehen ist;

Figur 2 die schaltungsgemäße Ausgestaltung eines zweiten Ausführungsbeispiels, bei dem der Oszillator der Mischstufe nachgesteuert wird, und

Figur 3 die Schaltung für einen Phasenmodulator mit Anpaßschaltung.

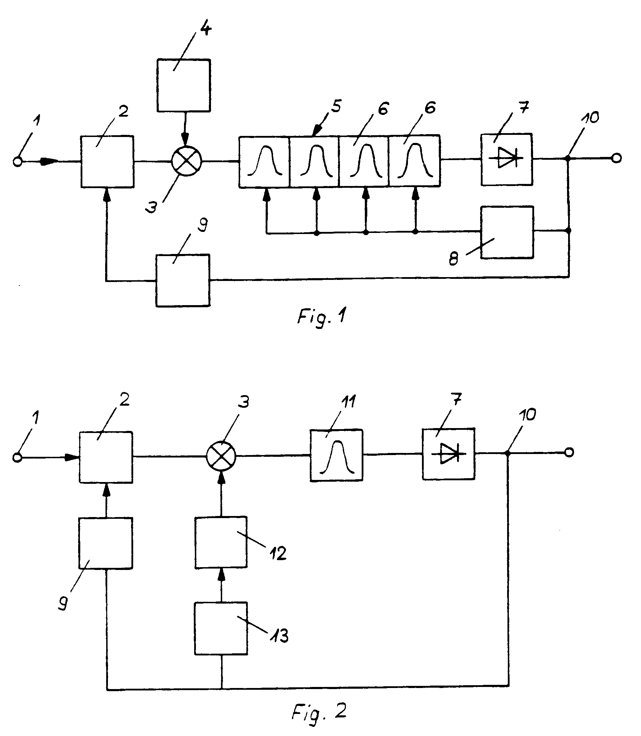

In Figur 1 ist mit 1 die Eingangsklemme der Schaltungsanordnung bezeichnet, an der die frequenzmodulierten Empfangssignale oder die zwischenfrequenten Ausgangssignale einer Zwischenfrequenzstufe liegen. Das Bezugszeichen 2 bezeichnet einen Phasenmodulator, der der Mischstufe 3 vor- bzw nachgeschaltet ist. Der Mischstufe 3 werden die Ausgangssignale eines Oszillators 4 zugeleitet. Der Ausgang der Mischstufe 3 ist an eine Filteranordnung 5 angeschlossen, die aus mehreren Mitlauffiltern 6 besteht. Die Filteranordnung 5 ist mit dem Eingang eines Demodulators 7 verbunden, an dessen Ausgang die niederfrequenten Signale anstehen. Diese sind über eine erste, der Filteranordnung 5 zugeordnete Anpaßschaltung 8 und über eine zweite, dem Phasenmodulator 2 zugeordnete Anpaßschaltung 9 rückgeführt.

Die modulierten hochfrequenten Empfangssignale bzw. die Zwischenfrequenzsignale gelangen über den gesteuerten Phasenmodulator 2 auf die Mischstufe 3, in der sie mit dem Ausgangssignal des Oszillators 4 zu am Ausgang der Mischstufe anliegenden zwischenfrequenten Signalen gemischt werden. Die Filteranordnung 5 filtert entsprechend ihrem Durchlaßbereich die Zwischenfrequenzsignale aus, die in dem Demodulator 7 zu Niederfrequenzsignalen demoduliert werden. Die niederfrequente Ausgangsspannung des Demodulators 7 wird der Filteranordnung 5 über die Anpaßschaltung 8, die als Spannungsteiler ausgebildet sein kann, der Filteranordnung 5 derart zugeführt, daß die Mittenfrequenz der Filter 6 der Momentanfrequenz des der Mischstufe 3 entnehmbaren zwischenfrequenten Signals nachgeführt wird. Außerdem wird aus dem niederfrequenten Ausgangssignal über eine weitere Anpaßschaltung 9 das Steuersignal für den Phasenmodulator 2 gewonnen. Der Phasenmodulator 2 moduliert die am Ausgang der Mischstufe 3 anliegende Zwischenfrequenz in der Weise, daß die sonst am Ausgang der Filteranordnung 5 vorhandenen Störmodulation kompensiert wird. Dazu muß die durch den Phasenmodulator 2 der Zwischenfrequenz aufgeprägten Modulation gegenphasig zur Störphasenmodulation sein. Die Gegenphasigkeit kann durch einen in der Anpaßschaltung 9 vorhandenen Inverter erfolgen, der das vom Ausgang der Schaltungsanordnung gelieferte Steuersignal invertiert. In einer anderen Ausführungsform können die der Verstimmung der Resonanzkreise bzw. der Nachsteuerbarkeit dienenden Steuerelemente der Mitlauffilter 6, die beispielsweise als Kapazitätsdioden ausgebildet sein können, eine zu den Steuerelementen des Phasenmodulators 2, die ebenfalls Kapazitätsdioden sein können, entgegengesetzte Polung aufweisen.

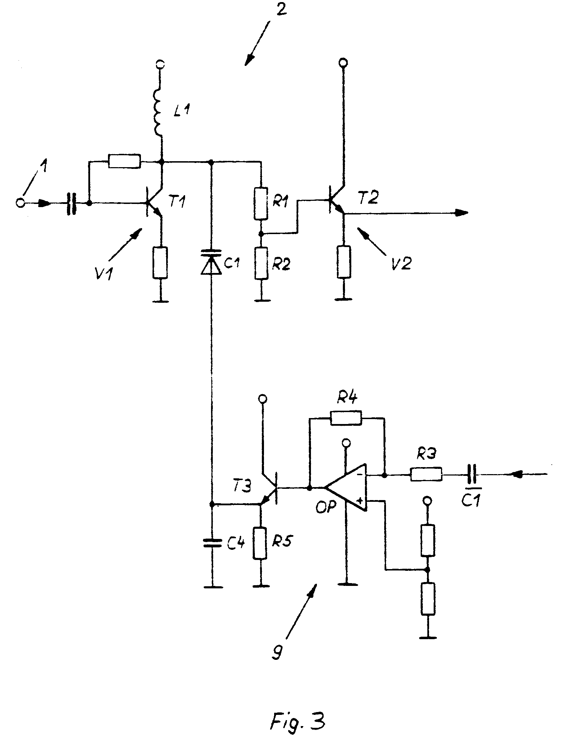

In Figur 3 ist die Ausführung eines Phasenmodulators 2 mit einer Anpaßschaltung 9 dargestellt. Der Phasenmodulator ist als einstufiger selektiver Verstärker ausgebildet, dessen Schwingkreis L1, C1 steuerbar ist. Die Steuerung erfolgt über die Kapazitätsdioden Z1, die mit der Anpaßschaltung 9 verbunden sind. Die Widerstände R1, R2 dienen zur Bedämpfung des Schwingkreises L1, C1 und zur galvanischen Kopplung von V1 mit der den Transistor T2 aufweisenden Trennstufe V2. Die Anpaßschaltung 9 weist einen Operationsverstärker OP auf, an dessen invertierenden Eingang über den Hochpaß R3, $\overline{C1}$ das Demodulatorausgangssignal gelangt. Die Grenzfrequenz von R3, $\overline{C1}$ beträgt bei Radioanwendung ca. 10 kHz. Der die Verstärkung des Operationsverstärkers OP beeinflussende Gegenkoppelwiderstand R4 wird auf bestmögliche Phasenkompensation bemessen. Über den Transistor T3 in Verbindung mit der Emitterbeschaltung R5, C4 wird die erforderliche Niederohmigkeit für das Zwischenfrequenz-Signal erreicht; der Emitter stellt für die Zwischenfrequenz gleichsam einen Kurzschluß dar. Die Anpaßschaltung kann möglicherweise einen nicht dargestellten Inverter umfassen.

Figur 2 zeigt ein weiteres Ausführungsbeispiel. Hier wird kein Mitlauffilter 6 verwendet, sondern ein schmalbandiges Selektivfilter 11, das nicht nachsteuerbar ist. Die Nachsteuerung erfolgt hier über einen Oszillator 12, der über eine Anpaßschaltung 13 mit dem Ausgang 10 des Demodulators 7 verbunden ist und durch die von dem niederfrequenten Ausgangssignal abgeleitete Steuerspannung in der Weise gesteuert wird, daß der Frequenzhub des Signals am Ausgang der Mischstufe 3 gering ist. Die Funktionsweise hinsichtlich der gegenphasigen Phasenmodulation entspricht der Ausführung nach Figur 1. In Figur 2 ist nur ein feststehendes Filter 11 dargestellt, selbstverständlich können mehrere Filter vorgesehen sein, entsprechend kann in Figur 1 nur ein Mitlauffilter verwendet werden. Der Phasenmodulator 2 ist in dem Ausführungsbeispielen vor der Mischstufe 3 angeordnet.

In den beschriebenen Ausführungsbeispielen wird die der Störphasenmodulation gegenphasige Modulation durch den Phasenmodulator erreicht. Anstelle der Verwendung eines Phasenmodulators liegt eine andere Möglichkeit zur Realisierung der zur Störphasenmodulation gegenphasigen Modulation in der Modulation der Oszillatorspannung der Mischstufe, die dann der Zwischenfrequenz aufgeprägt wird. Eine entsprechende Ausführungsvariante ergibt sich ohne weiteres durch entsprechende Veränderung des Ausführungsbeispiels gemäß Figur 2 und ist nicht näher dargestellt.

**Patentansprüche**

1.  Schaltungsanordnung zum Umsetzen frequenzmodulierter Signale über mindestens eine Zwischenfrequenz in Niederfrequenzsignale, bei der

    die Zwischenfrequenzsignale nach Mischung mit einer Oszillatorspannung und anschließendem Ausfiltern erzeugt und demoduliert werden, wobei

die Oszillatorspannung oder die Resonanzfrequenz des Filters mittels einer vom demodulierten Signal abgeleiteten Steuerspannung entsprechend der momentanen Zwischenfrequenz nachgeführt werden, so daß der jeweilige Momentanwert der Zwischenfrequenz stets innerhalb des Durchlaßbereichs des Filters liegt und die Zwischenfrequenz zu der durch die Steuerverzögerung der Nachführung auftretenden Störphasenmodulation gegenphasig moduliert wird,

mit

einer von einem Oszillator (4) angesteuerten Mischstufe (3),

mindestens einem Filter (5, 6, 11) zum Ausfiltern des Zwischenfrequenz-Signals und

einem dem Filter nachgeschalteten Demodulator (7), von dessen Ausgangsspannung eine Steuerspannung zum Nachsteuern der Oszillatorspannung oder der Resonanzfrequenz des Filters entsprechend der momentanen Zwischenfrequenz abgeleitet ist,

**dadurch gekennzeichnet,**

daß zur gegenphasigen Modulation der Störphasenmodulation, ein Phasenmodulator (2) vor die Mischstufe (3) geschaltet ist oder der Zwischenfrequenz durch Modulation der Oszillatorspannung eine Phasenmodulation aufgeprägt wird.

2. Schaltungsanordnung nach Anspruch 1, **dadurch gekennzeichnet,** daß eine dem Demodulator nachgeschaltete Anpaßschaltung (9) einen Inverter zum Invertieren der Steuerspannung aufweist.

3. Schaltungsanordnung nach einem der vorangehenden Ansprüche, **dadurch gekennzeichnet,** daß die Anpaßschaltung (9) einen Hochpaß (C1, R3) aufweist, der die hohen Frequenzbereiche der Niederfrequenz durchläßt und die niedrigen Frequenzbereiche sperrt.

4. Schaltungsanordnung nach einem der vorangehenden Ansprüche, **dadurch gekennzeichnet,** daß mehrere nachsteuerbare Filter (6) vorgesehen sind.

5. Schaltungsanordnung nach einem vorangehenden Ansprüche, **dadurch gekennzeichnet,** daß der Phasenmodulator (2) als selektiver Verstärker ausgebildet ist.

6. Schaltungsanordnung nach einem der vorangehenden Ansprüche, **dadurch gekennzeichnet,** daß der Phasenmodulator (2) eine breitbandige Charakteristik aufweist.

7. Schaltungsanordnung nach einem der vorangehenden Ansprüche, **dadurch gekennzeichnet,** daß bei der Nachsteuerung des Oszillators (12) das Filter (11) als festes schmalbandiges Selektivfilter ausgebildet ist.

## Claims

1. A circuit arrangement for converting frequency-modulated signals into low-frequency signals via at least one intermediate frequency, wherein the intermediate frequency signals are generated and demodulated after mixing with an oscillator voltage and subsequent filtering, wherein the oscillator voltage or the resonance frequency of the filter are tracked in accordance with the instantaneous intermediate frequency by means of a control voltage derived from the demodulated signal, so that the respective instantaneous value of the intermediate frequency always falls within the pass-band of the filter, and the intermediate frequency is modulated in phase opposition to the interference phase modulation which occurs as a result of the control delay of the tracking, comprising a mixer stage (3) which is driven by an oscillator (4), at least one filter (5, 6, 11) which serves to filter out the intermediate frequency signal, and a demodulator (7) which is connected to the output end of the filter and from the output voltage of which a control voltage is derived for tracking the oscillator voltage or the resonance frequency of the filter in accordance with the instantaneous intermediate frequency, characterised in that for the phase-opposed modulation of the interference phase modulation, a phase modulator (2) is connected to the input end of the mixer stage (3) or a phase modulation is impressed upon the intermediate frequency by modulating the oscillator voltage.

2. A circuit arrangement as claimed in Claim 1, characterised in that a matching circuit (9) which is connected to the output end of the demodulator comprises an inverter for the inversion of the control voltage.

3. A circuit arrangement as claimed in any preceding claim, characterised in that the matching circuit (9) comprises a high-pass filter (C1, R3) which transmits the high frequency bands of the low-frequency and blocks the low frequency bands.

4. A circuit arrangement as claimed in any preceding claim, characterised in that a plurality of trackable filters (6) are provided.

5. A circuit arrangement as claimed in any preceding claim, characterised in that the phase modulator (2) is designed as a selective amplifier.

6. A circuit arrangement as claimed in any preceding claim, characterised in that the phase modulator (2) has a wide bandwidth.

7. A circuit arrangement as claimed in any preceding claim, characterised in that when the oscillator (12) is tracked, the filter (11) is designed as a fixed, narrow-band selective filter.

**Revendications**

1. Agencement de circuit pour convertir en signaux à basse fréquence des signaux à modulation de fréquence, par au moins une fréquence intermédiaire, dans lequel

les signaux à fréquence intermédiaire sont produits et démodulés après mélange à une tension d'oscillateur suivi de filtrage,

la tension d'oscillateur, ou la fréquence de résonance du filtre, étant pilotée en mode poursuite en correspondance avec la fréquence intermédiaire momentanée au moyen d'une tension de commande tirée du signal démodulé, de sorte que la valeur momentanée concernée de la fréquence intermédiaire se trouve constamment à l'intérieur du domaine passant du filtre, et que la fréquence intermédiaire est modulée en opposition de phase avec la modulation perturbatrice survenant du fait du retard à la commande du pilotage en mode poursuite,

avec

un étage mélangeur (3), attaqué par un oscillateur (4),

au moins un filtre (5, 6, 11) pour le filtrage du signal à fréquence intermédiaire et

monté à la suite du filtre, un démodulateur (7) donnant une tension de sortie d'où est tirée une tension de commande pour la commande en mode poursuite de la tension d'oscillateur ou de la fréquence de résonance du filtre en fonction de la fréquence intermédiaire momentanée,

caractérisé

par le fait que, pour la modulation en opposition de phase de la modulation perturbatrice, un modulateur de phase (2) est monté avant l'étage mélangeur (3), ou une modulation de phase est imposée à la fréquence intermédiaire, par modulation de la tension d'oscillateur.

2. Agencement de circuit selon revendication 1, caractérisé par le fait qu'un circuit d'adaptation (9) en aval du démodulateur présente un inverseur pour inverser la tension de commande.

3. Agencement de circuit selon l'une des revendications précédentes, caractérisé par le fait que le circuit d'adaptation (9) présente un passe-haut (C1, R3) qui laisse passer les domaines à fréquence élevée de la basse fréquence et arrête les basses plages de fréquence.

4. Agencement de circuit selon l'une des revendications précédentes, caractérisé par le fait que plusieurs filtres aptes à être commandés (6) sont prévus.

5. Agencement de circuit selon l'une des revendications précédentes, caractérisé par le fait que le modulateur de phase (2) est réalisé en tant qu'amplificateur sélectif.

6. Agencement de circuit selon l'une des revendications précédentes, caractérisé par le fait que le modulateur de phase (2) présente une caractéristique à large bande.

7. Agencement de circuit selon l'une des revendications précédentes, caractérisé par le fait que, dans le cas de la commande de l'oscillateur dans le mode poursuite (12), le filtre (11) est réalisé en tant que filtre sélectif fixe à bande étroite.

Fig. 1

Fig. 2

Fig. 3